# EUROPEAN PATENT APPLICATION

(11) **EP 1 536 480 A1**
(43) Date of publication of application: **01.06.2005**
(21) Application number: 03425764.2
(22) Date of filing: 28.11.2003
(51) Int. Cl.: H01L 29/423, H01L 29/739, H01L 29/78

(54) **Semiconductor power device with insulated gate, trenchgate structure and corresponding manufacturing method**

(71) Applicant: STMicroelectronics S.r.l., 20041 Agrate Brianza (Milano) (IT)
(72) Inventor: Alessandria, Antonino Sebastiano, 95131 Catania (IT); Fragapane, Leonardo, 95121 Catania (IT); Magri, Angelo, 95032 Belpasso (CT) (IT)
(74) Representative: Ferrari, Barbara

(57) **Abstract**

The invention relates to a semiconductor power device (20) with insulated gate and improved trench-gate structure, of the type wherein the trench-gate structure is realised on a semiconductor substrate (1) covered by at least an epitaxial layer (3) and by means of a trench (29) realised in the semiconductor to form the device gate region (27); a dielectric coating (28) being provided on the inner and bottom walls of the trench (29), characterised in that said gate region (27) comprises a conductive spacer layer (30) on said coating layer (28) only in correspondence with the inner walls of the trench (29).

## Description

### Field of application

The present invention relates to a semiconductor power device with insulated gate and improved trench-gate structure.

More specifically, the invention relates to a device of said type wherein the trench-gate structure is realised on a semiconductor substrate covered by at least an epitaxial layer and through a trench realised in the semiconductor and filled in with a polysilicon layer to form the device gate region; a dielectric coating being provided on the trench inner and bottom walls.

The invention also relates to a manufacturing method of said semiconductor power device.

The invention particularly relates, but not exclusively, to a realisation of the trench-gate structure of a power device with a simplified process and improved performances and the following description is made with reference to this field of application for convenience of illustration only.

### Prior art

As it is well known in this specific technical field, power devices of the IGBT type (Insulated Gate Bipolar Transistor) are applied at best in the field of circuits requiring high voltage and current with a moderate switching frequency, such as the motor control or the use in continuity groups.

The performances thereof derive from the fact of having combined the advantages of a bipolar transistor (high conductivity) and those of a field-effect MOS transistor (control voltage with high input resistance), the second transistor driving the first base current.

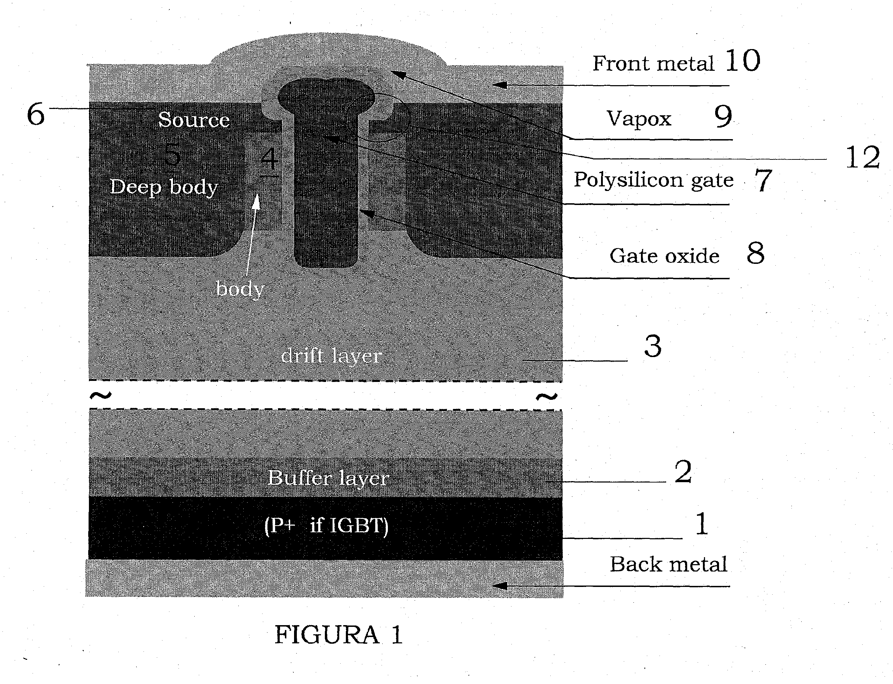

These IGBT devices can be generally manufactured in two versions: a first one called "planar gate" and another one called "trench-gate", whose cross-section can be seen in figure 1.

The structure of a "trench-gate" IGBT device comprises a substrate 1 of p+ semiconductor material whereon an epitaxial layer is grown, split into buffer layer 2 and drift layer 3, of the n+ and n- type respectively. Two differently-doped p regions are formed on the layer 3: the body 4 and a deep body 5. The source region 6 of the n type is integrated in the body region. Although the figure relates to an IGBT device, it is possible to consider also a Power MOS device ignoring the layer 1.

The trench-gate structure is realised by means of a trench realised in the silicon filled in with a polysilicon layer to form the gate region 7 and separated from the other portions by means of a silicon oxide coating 8 grown on the trench walls. A deposit of dielectric 9 and a metal contact 10 complete the device.

Regions 1 and 3 are the conduction electrodes of the bipolar transistor, while the MOS transistor comprises the source 6 and drift layer 3 regions and the gate 7.

The main advantages of a trench-gate device with respect to a device manufactured with the planar technology are the followings:
1) removal of the J-FET resistance with subsequent decrease in conduction losses,
2) possibility of considerably increasing the device integration scale with subsequent increase in the current density.

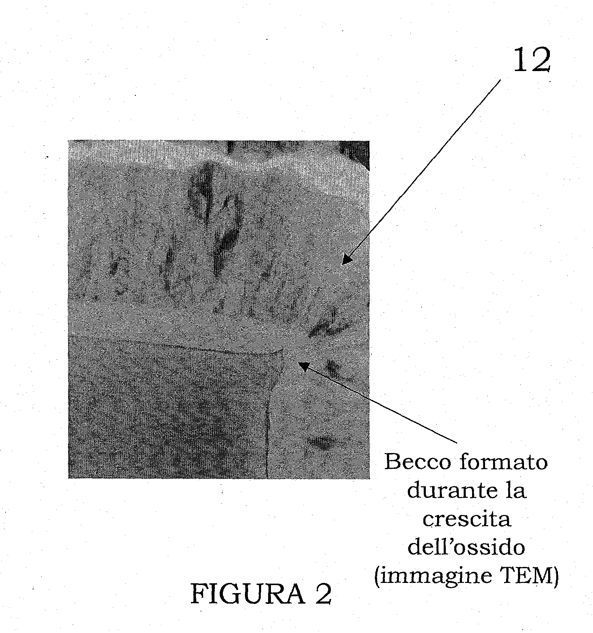

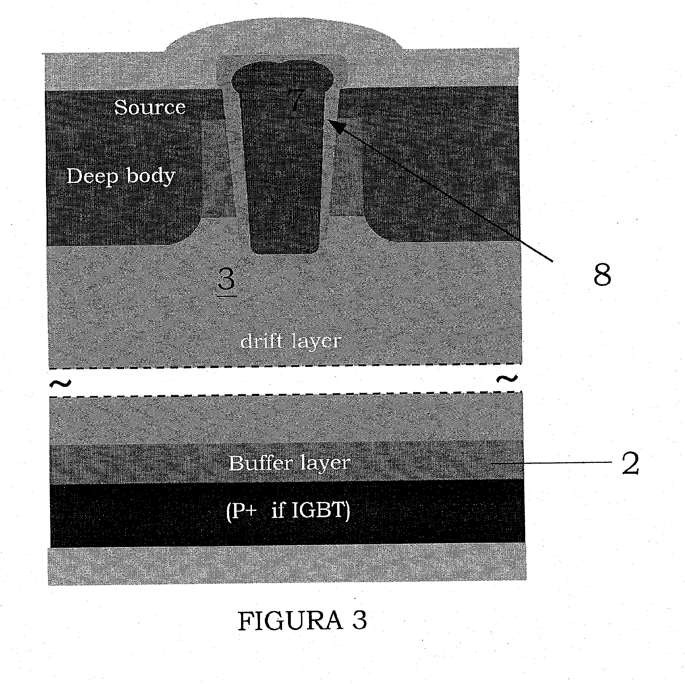

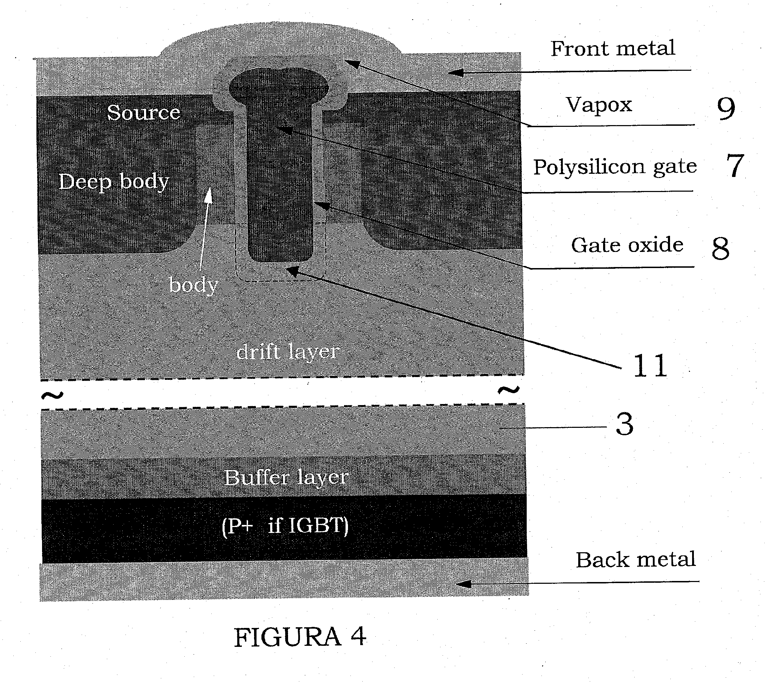

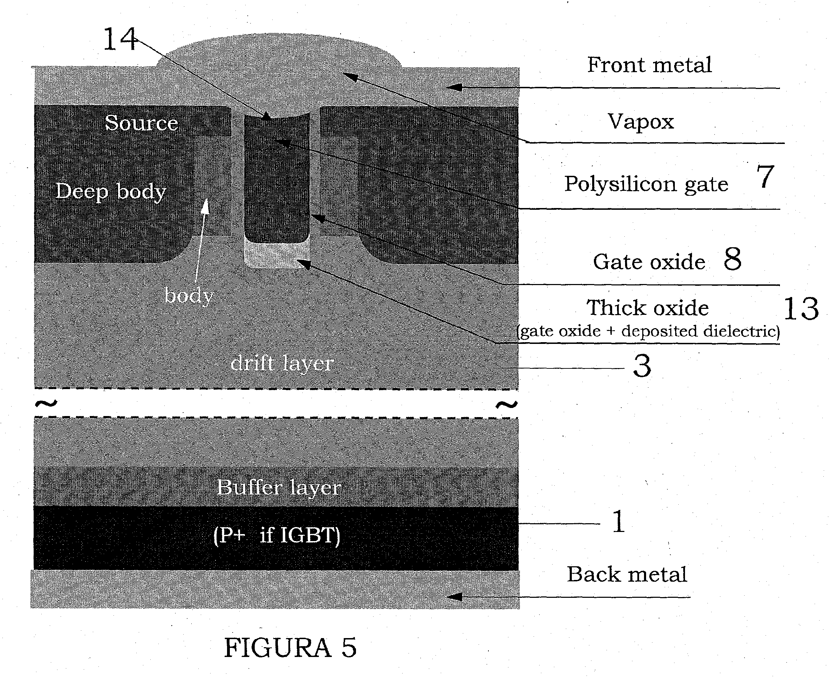

On the other hand, the structure has some drawbacks.
1) The trench lower portion causes a thickening of the electric field, with a subsequent worsening, for the same drift-layer thickness, of the device break-down voltage. A solution to this problem is provided, consisting in realising the trench lower portion with a U-profile. This trick considerably decreases the device break-down worsening.
2) The trench upper edge causes the formation of a beak during the gate oxide growth, which can be seen in figure 1 in the ring indicated with 12 and in a TEM image of the same region in figure 2. This unevenness causes a thickening of the electric field, due to the peak effect, with a subsequent worsening of the gate oxide break-down voltage.
   A first prior art solution to solve the problem consists in using a recessed polysilicon structure (etchback of the polysilicon protruding from the trench). In this way the edge at the trench upper end is cut out from the device active part.
   All this is shown in detail in figure 5, wherein the comparison with figure 1 clearly shows the effect of the polysilicon etchback even under the trench edge level, obtaining a concave surface 14. In this figure, all the regions in common with figure 1 have the same numbers.
   Another solution could be to try and round the trench upper edge, as shown in figure 3, when digging the silicon to avoid the formation of the oxide beak during the growth thereof. This solution is certainly more complex from the technological point of view.
   Moreover, the structure of a "trench-gate" IGBT device further has the following drawbacks:
3) The roughness of the trench vertical walls due to the silicon etching causes a damage of the carrier surface mobility, as well as a worsening of the gate oxide quality. In this case accurate cleaning processes and the growth of a sacrificial oxide on trench walls before forming the gate oxide, and the following removal thereof improve both the surface mobility and the gate oxide quality.
4) For the same device active area, a considerable increase of the gate oxide area occurs, even in useless areas, i.e. areas wherein the channel is not formed (gate oxide portion 11 in figure 4). This involves an increase in the stray capacities linked to the device gate terminal. This problem can be avoided by realising a thick oxide layer on the trench bottom. This solution improves both the device break-down (the oxide serves as field-ring) and the gate oxide break-down, since the wall portion, wherein a variation of the silicon crystallographic orientation occurs, is excluded from the thin oxide area, and the stray capacity linked to the gate terminal.

The structure resulting from these possible improvements is shown in figure 5 wherein the region filled in with Thick-oxide (gate oxide + deposited dielectric) is indicated with 13.

Although advantageous under many aspects, the above-indicated approach involves considerable complications due to the trench filling with LTO, to the polysilicon etchback with controlled overetch, etc.

The technical problem underlying the present invention is to provide a manufacturing method of a semiconductor power device with insulated gate and improved trench-gate structure, the method having such features as to allow the drawbacks mentioned with reference to the prior art to be overcome.

### Summary of the invention

The solution idea underlying the present invention is to realise the trench-gate structure by inserting a conductive spacer, for example of polysilicon, on the trench-gate inner walls.

On the basis of this solution idea the technical problem is solved by an electronic power device as previously indicated and defined in the characterising part of claim 1.

The problem is also solved by a method as previously indicated and defined in the characterising part of claim 9.

The features and advantages of the device and method according to the invention will be apparent from the following description of an embodiment thereof given by way of non-limiting example with reference to the attached drawings.

### Brief description of the drawings

In the drawings:
- Figure 1 is a cross-sectional schematic view of an IGBT or Power MOS power device with insulated trench-gate realised according to the prior art; the bird-beak structure of the silicon oxide being also underlined in the oval;
- Figure 2 is a blowup of the circled area of the previous figure 1;
- Figure 3 schematically shows a possible known solution with sloping trench walls to avoid the bird-beak;
- Figure 4 schematically shows a further known solution providing a gate oxide region adding stray capacity outside the channel region;
- Figure 5 schematically shows an improved structure with respect to figure 4 with recessed polysilicon and with the trench bottom being filled in with thick oxide;
- Figure 6 is a schematic view of a device with the improved trench-gate realised according to the invention;
- Figure 7 is a three-dimensional schematic view of the device of figure 6 with the trench-gate realised according to the invention;
- Figure 8 is a three-dimensional schematic view of the device realised according to the invention with a different polysilicon structure etching;
- Figure 9 is a cross-sectional schematic view of the device according to the invention with a drain engineering implant for a low-voltage MOS power;
- Figure 10 is a schematic view of the device according to the invention with an additional enrichment for an IGBT;
- Figure 11 is a cross-sectional schematic view of the device realised according to the invention with an additional silicide layer on the spacer;
- Figure 12 is a cross-sectional schematic view of the device according to the invention with an additional micro trench to realise a body-source short;
- Figure 13 shows the almost final structure of the device according to the invention wherein the contact opening is performed through the etch-back of an intermediate passivation layer.

### Detailed description

With reference to these figures, a power device 20 with insulated gate and improved trench-gate structure realised according to the invention by means of a conductive spacer, for example of polysilicon, is described.

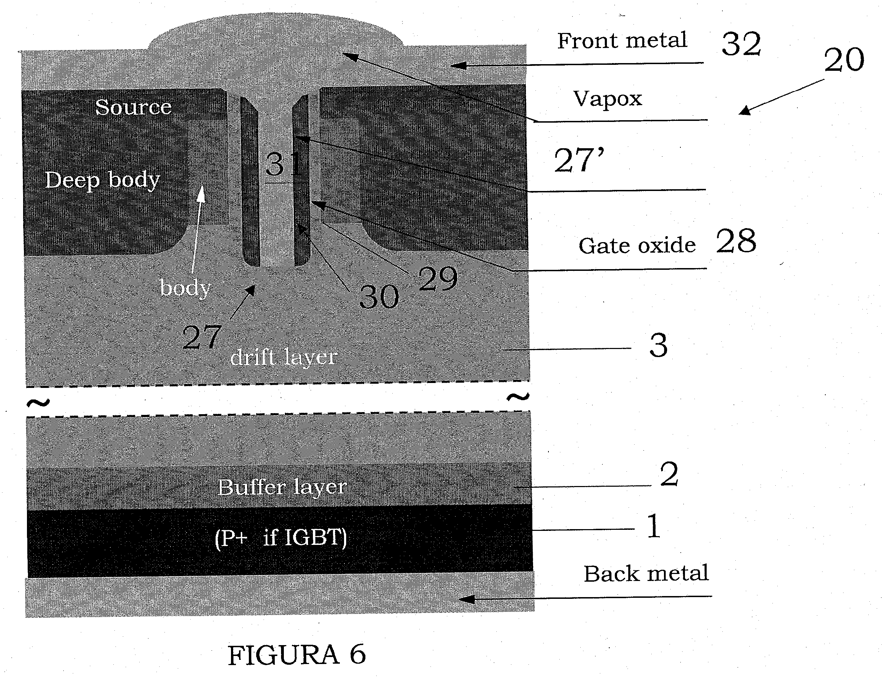

With particular reference to the example of figure 6, the sequence of steps of the method according to the invention leading to the formation of a power device of the above-mentioned type is shown hereafter.

The method steps and the structures being described hereafter do not form a complete process flow for manufacturing a power device. In fact, the present invention can be implemented together with the integrated circuit manufacturing techniques presently used in this field and only those commonly used process steps being necessary to understand the invention are described hereafter.

The figures representing cross sections of a semiconductor device during the manufacturing are not drawn to scale, but they are instead drawn in order to show the important features of the invention.

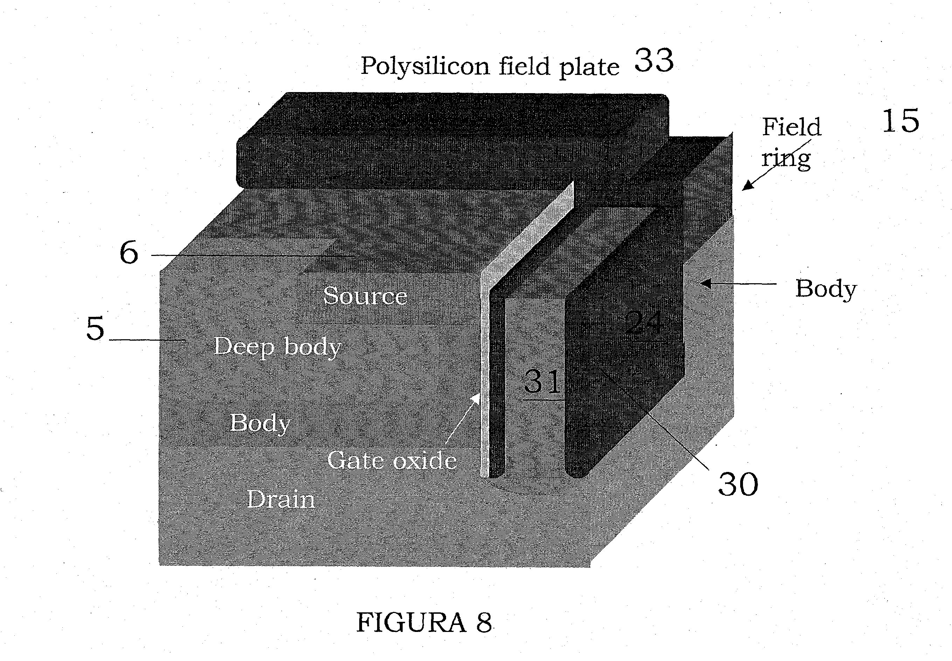

The method thus provides the following steps:
■ a starting substrate 1 of the N+ type for a MOS power or of the P+ type for an IGBT;
■ epitaxial growth of the N- type (drift layer) 3 with possible preventive growth of a buffer layer of the N+ type 2 at the interface with the substrate;
■ realisation of edge structures of the power device 20 by means of a field oxide and/or a field ring 15 of the P type implanted in the device peripheral region, as it can be better seen in figure 8. This implant is also used for realising the device mesh;
■ exposure of the device active area by removing the thick oxide;
■ realisation of the body structure 4 by means of an opencast implant of the P type;
■ realisation of the device deep body structure 5 by means of an implant of the P+ type with photoresist mask;
■ realisation of the source structure 6 by means of an implant of the N+ type with photoresist mask;
■ alignment of a hard mask for etching the semiconductor and forming a trench 29 to realise the gate region;
■ dry anisotropic etching of the semiconductor to realise a trench 29 having a U-profile in the lower or bottom portion;
■ hard mask removal;
■ cleaning and sacrificial oxidation of the inner walls of the trench 29 with subsequent oxide removal;
■ formation of a coating layer 28 coating the trench 29, to realise a dielectric gate layer, for example through oxidation;
■ deposit of a conductive layer 27', for example of polysilicon, for the partial filling of the trench 29; it is important that the trench is not completely closed, as it will be apparent from the following description;
■ formation of a conductive spacer 30 through dry anisotropic etching of the previously deposited layer 27' to define a gate 27 of the device 20. The etching has the end-point on the gate coating layer 28 both on the device top and in the trench 29 bottom;
■ filling of the trench 29 by means of the intermediate passivation dielectric 31;
■ continuation of the manufacturing process to define front metallisation contacts 32, final passivation and back metallisation according to the prior art.

Advantageously, the coating layer 28 is an oxide layer, while the conductive layer 27' is a polysilicon layer.

The process flow being described applies to the realisation of N-channel power devices with insulated gate; nevertheless nothing prevents essentially the same steps from being used, seeing to inverting the starting substrate and the varieties implanted to realise P-channel devices.

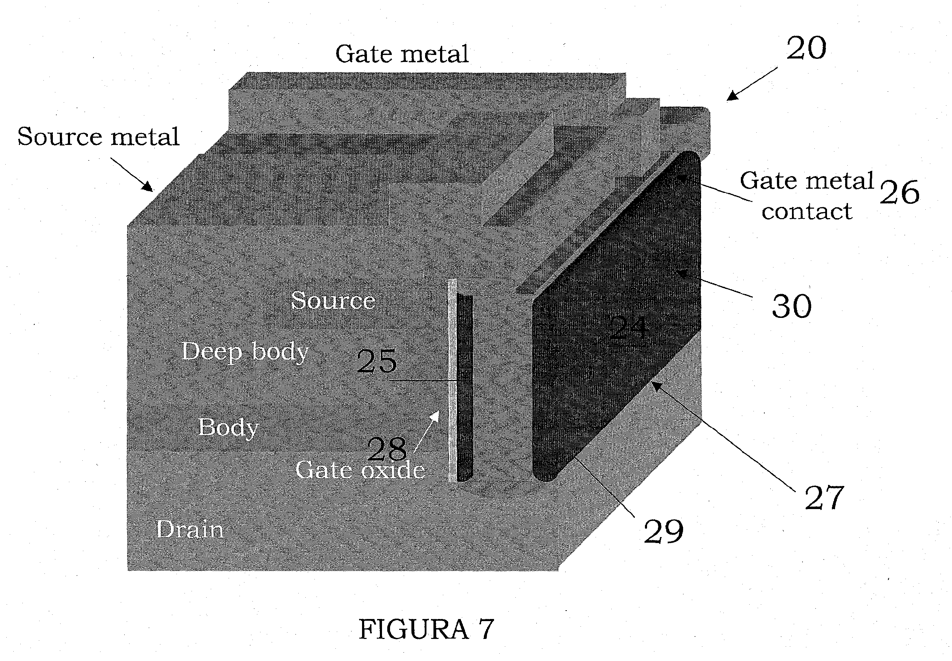

The etching to realise the polysilicon spacer 30 can be performed without mask. In this way, as it can be seen in figure 7, showing a three-dimensional section plane of the device realised according to the invention, the device gate structure will be formed by polysilicon stripes, two independent stripes 24, 25 for each trench, contacted by the metal gate 26 after etching the intermediate passivation 31 at the contact opening.

Therefore, the spacer 30 comprises the two independent conductive stripes 24, 25 being essentially parallel to each other, which are close to the coating layer 28 and realised only in correspondence with the trench 29 inner walls. On the contrary, the spacer 30 is not realised on the trench 29 bottom.

Alternatively, the spacer 30 etching can be performed with the mask in order not to etch the polysilicon in the edge region to realise the gate contact and the field-plate 33 in this region 26, as shown in figure 8.

The use of the described structure has the advantages being described hereafter.

The removal of the problem linked to the oxidation of the trench upper edge; in fact the polysilicon is recessed by the etching and the edge area does not belong to the active structure of the device gate (considerable improvement with respect to the structure shown in figure 1).

The portion of the device active area covered by the gate oxide only concerns the channel region; in fact the polysilicon is recessed from the trench top and it is removed from the trench bottom; this involves a decrease in the stray capacity linked to the device gate terminal (considerable improvement with respect to the structure shown in figure 1).

The simplification of the process with respect to the process being used to realise the structure shown in figure 5; in fact the process steps being necessary to realise the thick oxide 13 in the trench bottom are removed.

Moreover, the advantages achieved by realising the trench U-profile and those coming from the cleaning and sacrificial oxidation of trench walls are kept unchanged.

It must be noted that it is necessary to adjust the thickness of the deposited polysilicon layer with respect to the trench opening. In fact the polysilicon layer must not completely close the trench to allow the trench lower portion to be subsequently etched.

Moreover, as in the structure realised through polysilicon etchback, it is necessary that the thermal budget attributed to the dopant realising the device source is such that the source/body junction is deeper than the level whereto the polysilicon layer is recessed.

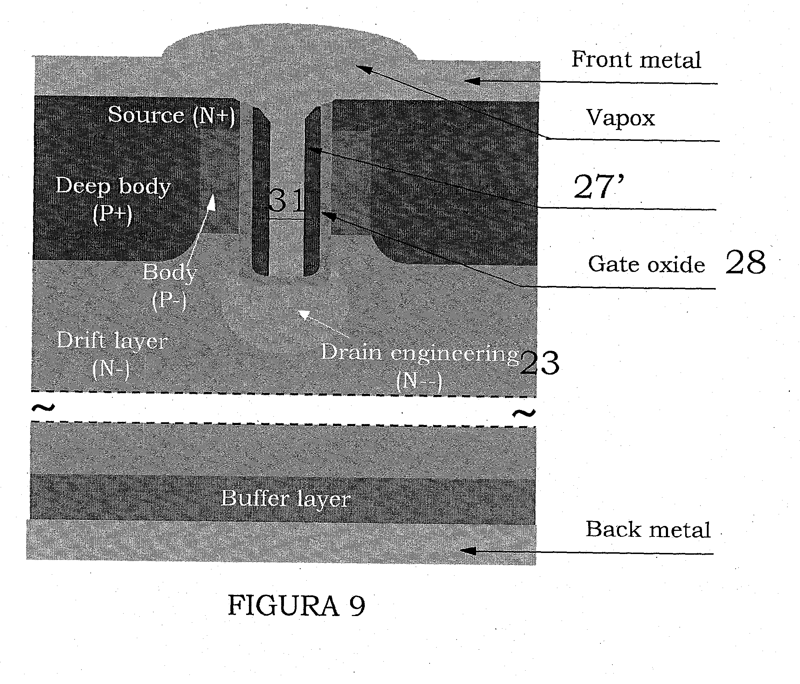

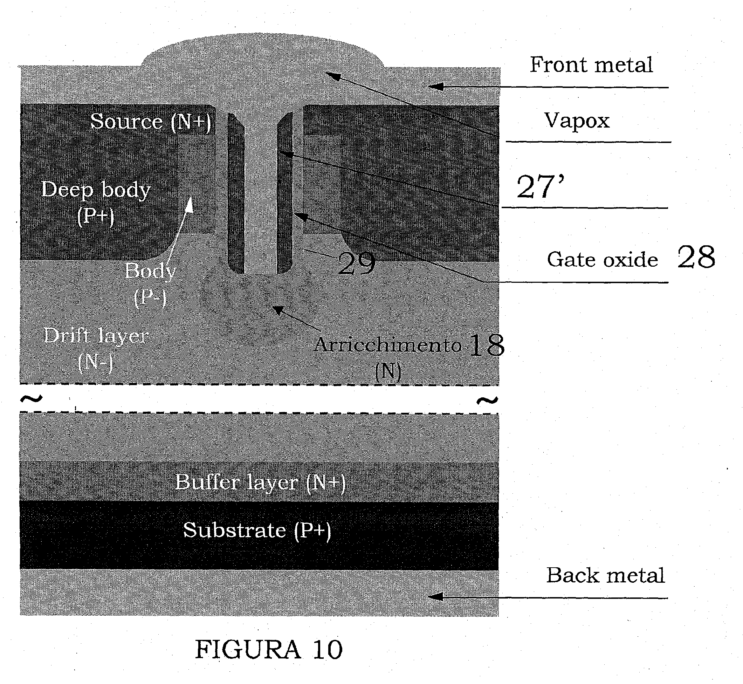

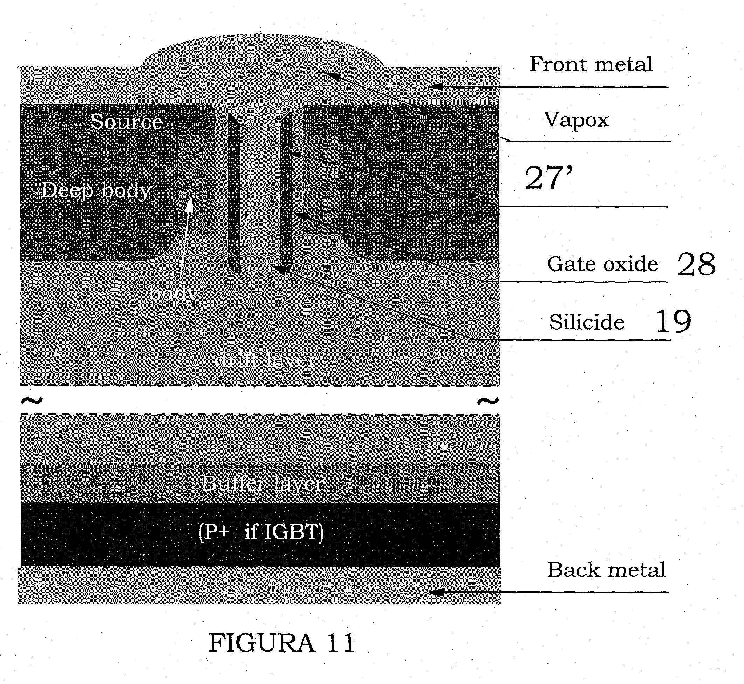

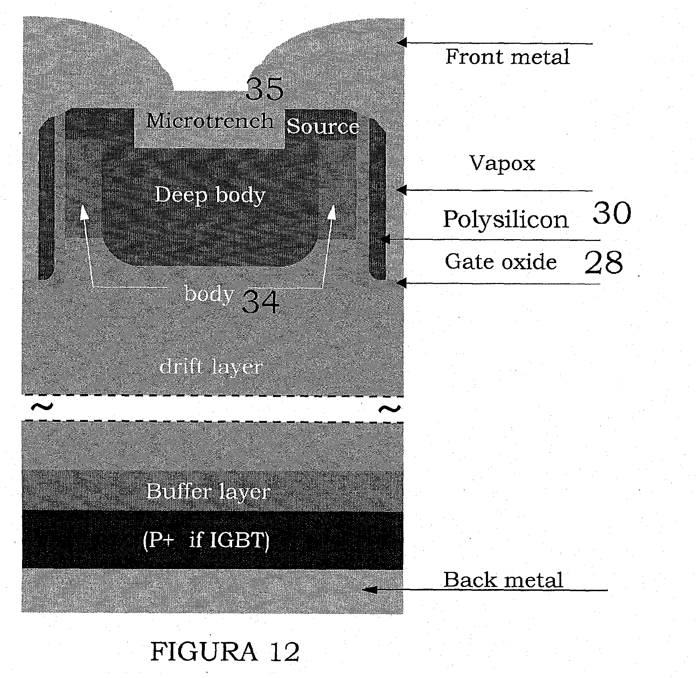

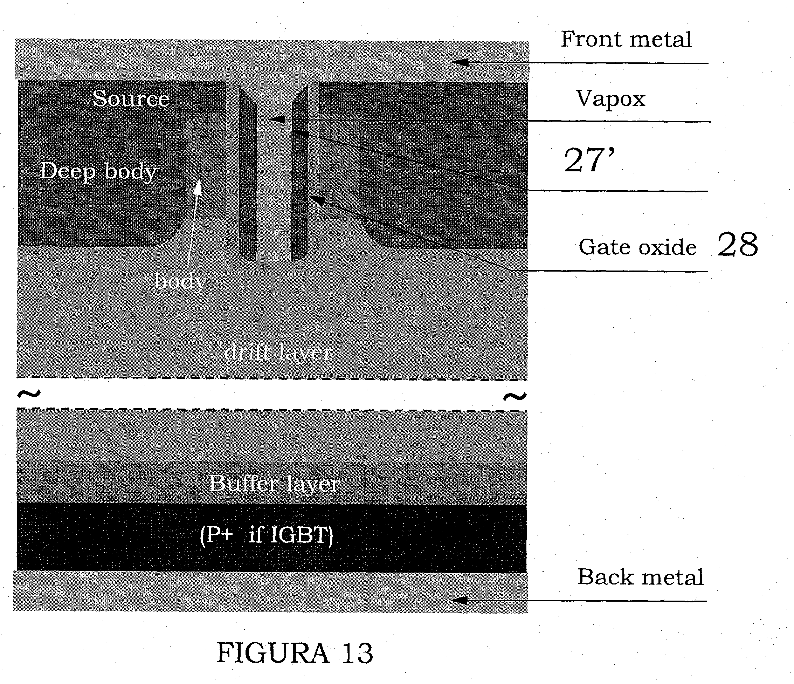

The final device structure shown in figure 6 can be further improved by means of some tricks being described hereafter.
■ In the case of a low-voltage MOS power, realisation of a "drain engineering" implant 23 after forming the trench. This implant would serve to impoverish the drift layer 3 region under the trench to impose, in the same region, a lower electric field slope. It is worth underlying that this trick would generate a self-aligned structure. The resulting structure is shown in figure 9.
■ In the case of an IGBT, realisation of an enrichment implant 18, as shown in figure 10, after forming the trench in the drift layer 3 region under the trench 29. This enrichment would favour, in this region, the effect, substantiated in literature, of the PIN diode formed by the P+ regions of the substrate 1, N- regions of the drift layer 3 and N_{enrichment} regions 18 under the trench. In this case too, the structure is self-aligned.
■ Formation of a silicide layer 19, as shown in figure 11, on the polysilicon spacer 30 defining the gate 27 of the device 20, to decrease the distributed gate resistance. This layer 19 is realised by sputtering a thin metal layer, sintering the silicide through a thermal process and removing the unsintered metal by acqua regia wet etching. In this case too, the process is self-aligned, i.e. it does not require additional phtotechniques. In fact, the silicide layer is formed only on the polysilicon, since the remaining silicon is covered by the gate oxide, even in the trench bottom.
■ In view of the number reduction of the masks being used, the dopant constituting the source can be implanted opencast and a body-source 34 short can be realised by means of a micro-trench 35 realised in the silicon in the contact opening step. The resulting structure is shown in figure 12 showing the portion comprised between two trench-gates 27 by means of the microtrench 35.
■ The contact opening can be performed through the etchback of the intermediate passivation dielectric 31. It thus results that the intermediate passivation dielectric 31 is completely comprised in the trench in the device 20 active area, as shown in figure 13. In this solution it is necessary to keep a convenient edge between the polysilicon recess level and the intermediate passivation dielectric etchback.

In conclusion, the device and method according to the invention solve the technical problem and they allow a semiconductor power device with insulated gate and trench-gate to be obtained, equipped with a conductive spacer, for example of polysilicon, and with definitely better production yields and performance features than prior art solutions.

## Claims

1. A semiconductor power device (20) with insulated gate and improved trench-gate structure, of the type wherein the trench-gate structure is realised on a semiconductor substrate (1) covered by at least an epitaxial layer (3) and by means of a trench (29) realised in the semiconductor to form the device gate region (27); a dielectric coating (28) being provided on the inner and bottom walls of the trench (29), **characterised in that** said gate region (27) comprises a conductive spacer layer (30) on said coating layer (28) only in correspondence with the inner walls of the trench (29).

2. A device according to claim 1, **characterised in that** said spacer layer (30) is made of polysilicon.

3. A device according to claim 1, **characterised in that** the epitaxial layer (3) under the trench (29) is interested by a drain implant (23).

4. A device according to claim 1, **characterised in that** the epitaxial layer (3) under the trench 29) is interested by an enrichment implant (18).

5. A device according to claim 2, **characterised in that** it comprises a silicide layer (19) on the polysilicon spacer (30) defining the gate (27) of the device (20), to decrease the distributed gate resistance.

6. A device according to claim 2, **characterised in that** the trench (29) bottom is free from polysilicon.

7. A device according to claim 1, **characterised in that** said trench (29) is filled in with intermediate passivation dielectric (31).

8. A device according to claim 1, **characterised in that** said device is provided with a body region and a source region being short-circuited with each other by means of a microtrench.

9. A device according to claim 1, **characterised in that** said intermediate passivation dielectric (31) is completely comprised in said trench (29).

10. A manufacturing method of a power device with insulated gate and improved trench-gate structure, of the type providing at least a step of:
■ semiconductor etching and formation of a trench (29) to realise said trench-gate structure;
■ formation of a gate coating layer (28) of the inner and bottom walls of said trench (29), **characterised in that** it further comprises:
■ a deposit of a conductive layer (27') for the partial filling of the trench (29);
■ the formation of a polysilicon spacer (30) through anisotropic dry etching of the conductive layer (27').

11. A method according to claim 10, **characterised in that** said conductive layer (27') is made of polysilicon.

12. A method according to claim 10, **characterised in that** said semiconductor etching is of the anisotropic dry type to realise a trench (29) with U-profile in the bottom portion or wall.

13. A method according to claim 10, **characterised in that**, after forming the trench (29), it provides a cleaning and sacrificial oxidation of the inner walls of the trench (29) with subsequent oxide removal.

14. A method according to claim 11, **characterised in that** said anisotropic dry etching step of the polysilicon layer (28) has an end-point on the gate coating layer (28) both on the device upper portion and on the trench (29) bottom.

15. A method according to claim 10, **characterised in that**, after realising the spacer (30), it provides the filling of the trench (29) by means of an intermediate passivation dielectric (31).

16. A method according to claim 10, **characterised in that** it provides the realisation of a "drain engineering" implant (23) after forming the trench (29) to impoverish said epitaxial layer (3) under the trench (29) to impose a lower electric field slope.

17. A method according to claim 10, **characterised in that** it provides the realisation of an enrichment implant (18) after forming the trench (29) and in the epitaxial layer (3) region under the trench (29).

18. A method according to claim 11, **characterised in that** it provides the formation of a silicide layer (19) on the polysilicon spacer (30) defining the gate (27) of the device (20) to decrease the distributed gate resistance.

19. A method according to claim 18, **characterised in that** said silicide layer (19) is realised by sputtering a thin metal layer, with following silicide sintering by means of a thermal process and removal of the unsintered metal by wet etching.

20. A method according to claim 15, **characterised in that** it provides a contact opening step through the etchback of the intermediate passivation dielectric (31).

21. A method according to claim 15, **characterised in that** it provides the further steps of:
■ formation of body and source regions in the substrate,
■ formation of a micro-trench in the substrate to realise a short-circuit between said body and source regions.
